(19) Europäisches Patentamt
European Patent Office
Office européen des brevets

(11) **EP 4 672 374 A1**

(12) **EUROPEAN PATENT APPLICATION**
published in accordance with Art. 153(4) EPC

(43) Date of publication:
**31.12.2025 Bulletin 2026/01**

(21) Application number: 24876655.2

(22) Date of filing: **11.10.2024**

(51) International Patent Classification (IPC):
*H01M 4/505* (2010.01)   *H01M 4/525* (2010.01)
*H01M 10/0525* (2010.01)   *C01G 53/00* (2025.01)

(52) Cooperative Patent Classification (CPC):
Y02E 60/10

(86) International application number:
**PCT/CN2024/124255**

(87) International publication number:
**WO 2025/077850 (17.04.2025 Gazette 2025/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.10.2023  CN 202311334878**

(71) Applicant: BTR NANO TECH CO., LTD.
Shenzhen, Guangdong 518106 (CN)

(72) Inventors:
• **LIU, Guoxue**
  **Shenzhen, Guangdong 518106 (CN)**

• **SHENG, Jinzhi**
  **Shenzhen, Guangdong 518106 (CN)**
• **ZHENG, Yu**
  **Shenzhen, Guangdong 518106 (CN)**
• **WU, Xiaozhen**
  **Shenzhen, Guangdong 518106 (CN)**
• **YANG, Shunyi**
  **Shenzhen, Guangdong 518106 (CN)**
• **HUANG, Youyuan**
  **Shenzhen, Guangdong 518106 (CN)**

(74) Representative: **advotec.**
**Patent- und Rechtsanwaltspartnerschaft mbB**
**Widenmayerstraße 4**
**80538 München (DE)**

(54) **POSITIVE ELECTRODE MATERIAL AND PREPARATION METHOD THEREFOR, AND BATTERY**

(57)     A cathode material, a preparation thereof and a battery provided. The cathode material has a chemical formula of $Li_nNi_{1-x-y}M_xMn_yO_2$, where $0.9 \leq n \leq 1.2$, $0 < x < 1$, $0 < y < 1$, and M is selected from Co and/or Al, the cathode material includes first particles with the maximum diameter of $\leq 1.5 \ \mu m$ and second particles with the maximum diameter of $22.5 \ \mu m$, by characterizing the first particles through energy dispersive spectroscopy (EDS), an average value of molar ratios of Ni element and Mn element is denoted as $R_1$, and by characterizing the second particles through energy dispersive spectroscopy (EDS), an average value of molar ratios of Ni element and Mn element is denoted as $R_2$, where $0 < R_2 - R_1$. Regarding the cathode material, the specific capacity and the initial efficiency performance as well as the structural stability and the cycle performance of the cathode material are effectively improved.

FIG. 2a

## Description

This application claims the benefit of priority to Chinese Patent Application 202311334878.4, filed on October 13, 2023, the entire content of which is incorporated herein by reference for all purposes.

## TECHNICAL FIELD

The present disclosure relates to the field of cathode material, particular to a cathode material, a preparation method thereof, and a battery.

## BACKGROUND

The lithium ion battery is widely applied in the fields of laptop, mobile phone, and digital product, etc. due to the advantages of high energy density, good safety performance, long cycle life, and environmental friendliness. While, the development of cathode material is slower than that of the anode material with large capacity (about 800 mAh/g to 1000 mAh/g). Therefore, the research and development personnel currently also focus on developing high-capacity and high-voltage cathode material for improving the energy density of a lithium ion battery.

A common ternary cathode material with a layered structure exhibits characteristics of high capacity, high voltage, good cycle life, and good safety, etc., thereby becoming a main cathode material for power battery development. However, with the increase of nickel content in the ternary cathode material, problems, such as Li/Ni mixing, structural degradation, reduced thermal stability, and increased residual alkali, etc., are inevitably caused, thereby leading to battery capacity degradation, cycle reduction, and poor structural stability, affecting the use with safety and high performance.

The hydroxide precursor prepared by the conventional co-precipitation method has the components such as uniformly distributed nickel-cobalt-manganese based hydroxide, which keeping uniformly distributions of the element ratios of Ni, Co and Mn during the sintering together with lithium salt. Generally, in order to reduce dislocation defect caused by the Li/Ni mixing, a mass content of nickel has to be properly reduced, which, however, inevitably requires sacrificing performances such as high capacity, high initial efficiency, etc. of the material.

Therefore, how to improve structural stability and cycle performance while improving the specific capacity and initial efficiency performance of the cathode material is one of the problems still to be solved at present.

## SUMMARY

An object of the present disclosure is to provide a cathode material, a preparation method thereof, and a battery. Regarding the cathode material of the present disclosure, the specific capacity and the initial efficiency performance as well as the structural stability and the cycle performance of the cathode material are effectively improved.

In a first aspect, embodiments of the present disclosure provide a cathode material. The cathode material has a chemical formula of $Li_nNi_{1-x-y}M_xMn_yO_2$, where $0.9 \leq n \leq 1.2$, $0 < x < 1$, $0 < y < 1$, and M is selected from Co and/or Al.

The cathode material includes first particles with the maximum diameter of $\leq 1.5\ \mu m$ and second particles with the maximum diameter of $\geq 2.5\ \mu m$.

By characterizing the first particles through energy dispersive spectroscopy (EDS), an average value of molar ratios of Ni element and Mn element is denoted as $R_1$.

By characterizing the second particles through energy dispersive spectroscopy (EDS), an average value of molar ratios of Ni element and Mn element is denoted as $R_2$, and $0 < R_2 - R_1$.

In a second aspect, embodiments of the present disclosure provide a preparation method of the cathode material, including the following steps:

performing primary sintering on a mixture including an oxide precursor of the cathode material, a lithium source and a metal M-containing dopant, and crushing a product of the primary sintering to obtain the cathode material, where by testing through XRD ray, the oxide precursor of the cathode material has diffraction peaks both at 34.4° to 36.4° and at 42.3° to 44.3°.

In a third aspect, embodiments of the present disclosure provide a battery. The battery includes the cathode material.

Compared with the prior art, the present disclosure has the following beneficial effects:

In the cathode material provided by the present disclosure, the first particles with the maximum diameter of $\leq 1.5\ \mu m$ and the second particles with the maximum diameter of $\geq 2.5\ \mu m$ are agglomerated to form the cathode material, so that the crystal structure mechanics of the second particles with a larger size is more stable, improving the structural stability of the cathode material, and the first particles with smaller size provide larger specific surface area and activity to increase the lithium storage sites, improving the discharge capacity of the cathode material. In addition, in the present disclosure, by further controlling the molar ratio of Ni element and Mn element of the first particles and the molar ratio of Ni element and Mn element of the second particles to be different, the Ni content of the first particles is relatively low, reducing the possibility of lattice defect and oxygen precipitation caused by the Ni mixing in the first particles, thereby reducing the side reaction on the surface of the particles. The second particles have a more stable crystal structure mechanics due to the large particle size thereof, based on this, the Ni content of the second particles is relatively high. Thus, even if there is dislocation defect caused by a little of the Ni mixing in the second particles, the generated internal stress is relieved through the overall dimension, the deterioration of the crystal structure is relieved, and the mixing and oxygen precipitation phenomena are avoided, thereby reducing the collapse of the particles. Therefore, when the cathode material satisfies the particle sizes and the element distribution relationship mentioned above, the structural stability of the material is effectively improved, the particle collapse is reduced, and the cycle performance and the capacity retention are improved.

In the preparation method of the cathode material provided by the present disclosure, the adopted cathode material precursor has diffraction peaks both at 34.4° to 36.4° and at 42.3° to 44.3°. Where, the diffraction peak at 42.3° to 44.3° indicates that a portion of the particles in the cathode material precursor exhibit rock-salt phase, such as NiO in the rock-salt phase; the diffraction peak at 34.4° to 36.4° indicates that a portion of particles in the cathode material precursor exhibit spinel phase, such as $NiMn_2O_4$. The precursor particles in the rock-salt phase tend to nucleate and grow into particles with a relatively large particle size during the sintering together with lithium salt, resulting in the sintered primary particles with a relatively large maximum diameter and a high nickel content, while the crystal structure thereof is more stable, allowing to withstand higher nickel content without structural collapse. The precursor particles in the spinel phase have a high nucleation energy barrier during the sintering together with lithium salt, resulting in the sintered primary particles with a relatively small maximum diameter and a low nickel content, reducing the possibility of lattice defect and oxygen precipitation caused by the Ni mixing, thereby reducing the side reaction on the surfaces of the particles. Therefore, for the cathode material prepared by sintering the above precursor, the structural stability of the material is effectively improved, the particle collapse is reduced, and the cycle performance and capacity retention of the material are improved.

## BRIEF DESCRIPTION OF DRAWINGS

In order to make the technical solutions according to the embodiments or prior art of the disclosure more apparent, the drawings to which a description of the embodiments or prior art refers to will be introduced below in brief, and apparently the drawings to be described below are only some embodiments of the disclosure, and those ordinarily skilled in the art can further drive from these drawings other drawings without any inventive effort.

FIG. 1 is a flow chart of a preparation method of the cathode material provided by embodiments of the present disclosure;

FIG. 2a is an XRD pattern of the oxide precursor of the cathode material provided by Example 1 of the present disclosure.

FIG. 2b is an SEM image of the oxide precursor of the cathode material provided by Example 1 of the present disclosure.

FIG. 2c is an SEM image of the cathode material provided by Example 1 of the present disclosure.

FIG. 2d is a sectional view and an EDS result of the cathode material provided by Example 1 of the present disclosure.

FIG. 3a is an XRD image of the oxide precursor of the cathode material provided by Example 2 of the present disclosure.

FIG. 3b is an SEM image of the oxide precursor of the cathode material provided by Example 2 of the present disclosure.

FIG. 3c is an SEM image of the cathode material provided by Example 2 of the present disclosure.

FIG. 3d is a sectional view and an EDS result of the cathode material provided by Example 2 of the present disclosure.

FIG. 4a is an XRD image of the oxide precursor of the cathode material provided by Comparative Example 1 of the present disclosure.

FIG. 4b is an SEM image of the oxide precursor of the cathode material provided by Comparative Example 1 of the present disclosure.

FIG. 4c is an SEM image of the cathode material provided by Comparative Example 1 of the present disclosure.

FIG. 4d is a sectional view and an EDS result of the cathode material provided by Comparative Example 1 of the present disclosure.

## DESCRIPTION OF EMBODIMENTS

In order to better understand the technical solution of the present disclosure, embodiments of the present disclosure are described in detail below with reference to the accompanying drawings.

It is to be made clear that the described embodiments are only some rather than all of the embodiments of the present disclosure. All other embodiments obtained by those skilled in the art without creative efforts according to the embodiments of the present disclosure are within the scope of the present disclosure.

In addition, the terms "first" and "second" are merely used for descriptive purposes, and should not be understood as indicating or implying relative importance or implicitly indicating the quantity of the indicated technical features. Therefore, a feature defined by "first" and "second" can indicate or imply to include one or more of the feature.

For ease of understanding the present disclosure, specific terms are properly defined in the present disclosure. Unless otherwise defined herein, scientific terms and technical terms used in the present disclosure have meanings commonly understood by those skilled in the art to which the present disclosure belongs.

As used herein, the term "matrix" refers to a lithium-based composite oxide synthesized by mixing a precursor with a lithium salt and performing a high-temperature solid-phase reaction, and includes lithium and a metal element.

As used herein, the term "primary particle" refers to a particle that is present alone without agglomeration.

As used herein, the term "secondary particle" refers to a particle formed by agglomeration of the primary particles.

Embodiments of the present disclosure provide a cathode material. The cathode material has a chemical formula of $Li_nNi_{1-x-y}M_xMn_yO_2$, where $0.9 \leq n \leq 1.2$, $0<x<1$, $0<y<1$, and M is selected from Co and/or Al.

The cathode material includes first particles with the maximum diameter of $\leq 1.5$ μm and second particles with the maximum diameter of $\geq 2.5$ μm.

By characterizing the first particles through energy dispersive spectroscopy (EDS), an average value of molar ratios of Ni element and Mn element is denoted as $R_1$.

By characterizing the second particles through energy dispersive spectroscopy (EDS), an average value of molar ratios of Ni element and Mn element is denoted as $R_2$, and $0<R_2-R_1$.

In the cathode material provided by the present disclosure, the first particles with the maximum diameter of $\leq 1.5$ μm and the second particles with the maximum diameter of $\geq 2.5$ μm agglomerated to form the cathode material, so that the crystal structure mechanics of the second particles with a larger size is more stable, improving the structural stability of the cathode material, and the first particles with smaller size provide larger specific surface area and activity to increase the lithium storage sites, improving the discharge capacity of the cathode material. In addition, in the present disclosure, by further controlling the molar ratio of Ni element and Mn element of the first particles and the molar ratio of Ni element and Mn element of the second particles to be different, the Ni content of the first particles is relatively low, reducing the possibility of lattice defect and oxygen precipitation caused by the Ni mixing in the first particles, thereby reducing the side reaction on the surface of the particles. The second particles have a more stable crystal structure mechanics due to the large particle size thereof, based on this, the Ni content of the second particles is relatively high. Thus, even if there is dislocation defect caused by a little of the Ni mixing in the second particles, the generated internal stress is relieved through the overall dimension, the deterioration of the crystal structure is relieved, and the mixing and oxygen precipitation phenomena are avoided, thereby reducing the collapse of the particles. Therefore, when the cathode material satisfies the particle sizes and the element distribution relationship mentioned above, the structural stability of the material is effectively improved, the particle collapse is reduced, and the cycle performance and the capacity retention are improved.

Specifically, a value range of n may be 0.9, 0.92, 0.94, 0.95, 0.98, 1.0, 1.02, 1.05, 1.08, 1.1, 1.12, 1.14, 1.16, 1.18, or 1.2, etc., or other value within the above range. A value range of x may be 0.1, 0.2, 0.3, 0.4, 0.5, 0.6, 0.7, 0.8, 0.9, or 0.92, etc. A value range of y may be 0.06, 0.1, 0.2, 0.28, 0.3, 0.4, 0.5, 0.6, 0.7, 0.8, 0.9, or 0.92, etc.

In some embodiments, in the cathode material, $R_1>0.5$, which may specifically be 0.52, 0.6, 0.7, 0.8, 0.9, 1.0, 1.3, 1.4, 1.5, 1.6, 1.8, 1.87, 1.9, etc., which is not limited herein.

In some embodiments, in the cathode material, $R_2>0.6$, which may specifically be 0.65, 0.7, 0.8, 0.9, 1.0, 1.2, 1.5, 1.8, 1.9, 1.93, 1.94, 1.95, 2.0, 2.01, 2.1, 2.2, etc., which is not limited herein.

In some embodiments, $0<R_2-R_1<0.5$, which may specifically be 0.01, 0.05, 0.1, 0.2, 0.3, 0.4, 0.5, etc., which is not limited herein. In the range of $R_2-R_1$, there are advantages of the large particles having high Ni content and the small particle having low Ni content, realizing a gradient Ni content in the large and small particles based on maintaining the uniform overall distribution of the main element, allowing the material to having higher structural stability, relieving the collapse of lattice structure, thereby improving the capacity and the cycle performance.

In some embodiments, the first particles have an average particle size of 0.5 μm to 1.5 μm. Controlling the particle size within the above range reduces the occurrence of side reaction and improves the structural stability of the particles.

In some embodiments, the second particles have an average particle size of 2.5 μm to 3.5 μm. Controlling the particle size within the above range is beneficial to diffusion and transport of lithium ions, reduces the internal resistance among particles, and improves the capacity and rate performance of the material. Preferably, the second particles have an average particle size of 2.6 μm to 3.5 μm.

It can be understood that, in the present disclosure, the first particles with the maximum diameter of $\leq 1.5$ μm and the second particles with the maximum diameter of $\geq 2.5$ μm are agglomerated to form the cathode material, so that the crystal structure mechanics of the second particles with a larger size is more stable. Even if there is dislocation defect caused by a little of the Ni mixing therein, the generated internal stress is relieved through the overall dimension, the deterioration of the crystal structure is relieved, and the mixing and oxygen precipitation phenomena are avoided, and more lithium storage activity is provided, thereby improving the capacity of the cathode material. The first particles with smaller size have a low content of Ni, which reduces the possibility of lattice defect and oxygen precipitation caused by the Ni mixing from the source, the crystal structure is more stable, and the side reaction on the surface of the cathode material is reduced. Further, the first particles have relatively larger specific surface area, which provides high activity to increase the lithium storage site, thereby increasing the discharge capacity of the cathode material.

In some embodiments, the cathode material has a chemical formula of $Li_nNi_{1-x-y}M_xMn_yM2_zO_2$, where $0 \leq z < 1$, and the M2 metal includes at least one of Zr, Mg, Ti, Ba, Sr, Cr, Zn, V, Cu, Nb, Mo, Sb, Ta, Ca, B, Y and W. Specifically, a value range of z may be 0, 0.1, 0.2, 0.3, 0.4, 0.5, 0.6, 0.7, 0.8, 0.9 or 0.92, etc., or other value within the above range.

In some embodiments, the cathode material has a chemical formula of $Li_nNi_{1-x-y}M_xMn_yM2_zM3_uO_2$, where $0 \leq z < 1$, the M2 metal includes at least one of Zr, Mg, Ti, Ba, Sr, Cr, Zn, V, Cu, Nb, Mo, Sb, Ta, Ca, B, Y and W, and the M3 metal includes at least one of Zr, Mg, Ti, Ba, Sr, Cr, Zn, V, Cu, Nb, Mo, Y, B and W.

In some embodiments, the cathode material has a sulfate content of $\leq 800$ ppm. In the cathode material of the present disclosure, $SO_4^{2-}$ has a large influence on the electrochemical performance of the material: If the content of $SO_4^{2-}$ is relatively high, $SO_4^{2-}$ is combined with $Li^+$ and a portion of $Li^+$ is bound, which is not beneficial to Li migration, leading to deterioration of the capacity and rate of the material. In addition, $SO_4^{2-}$ also affects the stability of the SEI film, resulting in reduction of the cycle performance. Controlling the sulfate content of the cathode material of the present disclosure within the above range effectively inhibits the adverse effects, thereby further improving the electrochemical performance of the cathode material.

In some embodiments, the cathode material precursor has a chemical formula of $Ni_aM_bMn_cO$, where $0 < a < 1$, $0 < b < 1$, $0 < c < 1$, and $a+b+c=1$, and M is selected from Co and/or Al. The cathode material precursor refers to a substance that is able to be converted into the cathode material of the present disclosure.

In some embodiments, the cathode material precursor has a chemical formula of $Ni_aCo_bMn_c(OH)_2$, where $0 < a < 1$, $0 < b < 1$, $0 \leq c < 1$, and $a+b+c=1$.

Specifically, by testing through XRD ray, the cathode material precursor has diffraction peaks both at $35.4° \pm 1°$ and at $43.3° \pm 1°$. Where, the diffraction peak at $35.4° \pm 1°$ indicates that a portion of the particles in the cathode material precursor exhibit rock-salt phase, such as NiO in the rock-salt phase; a portion of particles exhibit spinel phase, such as $NiMn_2O_4$. The precursor particles in the rock-salt phase are sintered to form particles with a relatively large particle size, resulting in the sintered primary particles with a relatively large maximum diameter and a high nickel content. The precursor particles in the spinel phase are sintered to form particles with a relatively small particle size, resulting in the sintered primary particles with a relatively small maximum diameter and a low nickel content.

In some embodiments, the cathode material is a single-crystal material. The single-crystal material includes a plurality of crystal grains. The crystal grain includes a plurality of primary particles. The plurality of primary particles include first particles and/or second particles. All the primary particles in at least one of the crystal grains exhibit identical orientation. A single crystal grain has an average particle size of 1 μm to 5 μm. Compared with a traditional polycrystalline material, the single-crystal material has a more stable structure, more uniform bulk composition distribution and better particle strength, which greatly reduces cracking of the particles during pressing an electrode plate, improves compaction density and volumetric energy density of the electrode plate, and is beneficial to the overall energy density of the battery. Further, the generation of microcracks in the polycrystalline material aggregates during cycling is avoided, thereby leading to improvements in the high-voltage performance and the cycle stability. It should be noted that the single crystal grain herein is formed by agglomeration of a plurality of primary particles, and the first particle and the second particle are both primary particles. The single crystal grain may be composed of the first particles, of the second particles, of a mixture of the first particles and the second particles, or of the first particles, the second particles, and primary particles with a maximum diameter between the first particle and the second particle.

In some embodiments, the cathode material is a single-crystal material. The single-crystal material includes a plurality of crystal grains. The crystal grain includes a plurality of primary particles. The plurality of primary particles include first particles and/or second particles. So the primary particles in at least one of the crystal grains exhibit identical orientation. A single crystal grain has an average particle size of 1 μm to 5 μm. The single grain exhibiting identical orientation contained in the cathode material is tested by an electron backscatter diffraction (EBSD). Observing the color of single primary particles in a crystal grain determines whether the crystal grain contains a single grain in which all the primary particles exhibiting identical orientation. Then, observing and measuring EBSD or SEM images determines the particle size of the selected single particle exhibiting identical orientation (i.e., the average particle size of the single grain).

It should be noted that the orientation of the primary particles in the crystal grain of the cathode material is at least tested by the electron backscatter diffraction (EBSD). 100 single crystal grains exhibiting identical orientation are randomly selected to measure the particle sizes of each crystal grains, and an arithmetic average value is calculated as the average particle size of the above single crystal grains.

The single-crystal cathode material is different from the polycrystalline ternary cathode material (i.e., polycrystalline secondary particle) in that: the polycrystalline secondary particle is a secondary particle formed by agglomeration of the primary particles. In contrast, for the single-crystal cathode material, its smallest particle is usually a micron-sized single primary particle. Generally, in addition to the testing by EBSD, whether the obtained cathode product is a single-crystal material is also determined by characterization means such as scanning electron microscopy (SEM), transmission electron microscopy (TEM), and X-ray diffraction (XRD), etc. For the conventional single-crystal cathode material, SEM is also an important and reliable characterization method. The single-crystal particle generally appears a shape of a regular or irregular polyhedron, without significant particle agglomeration. TEM is an auxiliary second characterization method, for observing whether the crystal plane orientation of an obtained product is consistent and further characterizing in combination with a selective area electron diffraction (SAED). The above methods are all used to determine single-crystal cathode material. For the convenience of understanding, the single-crystal cathode material of the present disclosure can be understood to contain a cathode material particle in which all the primary particles in at least one of the crystal grains exhibit identical orientation and the single crystal grain has an average particle size of 1 $\mu$m to 5 $\mu$m.

It can be understood that the single crystal grain in the present disclosure is a single particle composed of one primary particle. The single-crystal cathode material may also contain a little of "secondary particle-like particles" formed by adhesion of several single-crystal particles. The "primary particle" refers to a minimum particle unit recognized by observing the cathode active material through a scanning electron microscope. The "secondary particle" refers to a secondary structure formed by agglomeration of a plurality of the primary particles, which exhibits a relatively rounded spherical morphology. The "secondary particle-like particle" refers to a particle formed by adhesion of several single particles, and the single particle in the secondary particle-like particle usually has a particle size of 1 $\mu$m to 5 $\mu$m. In general, the "secondary particle-like particle" has a lower particle roundness than that of the conventional "secondary particle".

It should be noted that the "single-crystal cathode material" known to those skilled in the art is not a strictly "monocrystal". In crystallography, an ideal monocrystal refers to a crystal exhibiting exactly identical arrangement and orientation. However, limited by impurities, strain and crystalline defects, an ideal monocrystal is very rare and difficult to produce in a laboratory. Therefore, the single-crystal cathode material known in the art, in reality, is more accurately a "monocrystal-like morphology" cathode material, which only exhibits a large particle size like the monocrystal in size and is different from a polycrystal composed of numerous small primary particles.

In some embodiments, the cathode material has a median particle size of satisfying 2.5 $\mu$m $\leq$ the median particle size $\leq$5 $\mu$m, where the median particle size is particle size $D_{50}$. If the single-crystal particle has a too large particle size, the ion transport path is increased, and the internal resistance of the particles increased, resulting in slowing the reaction kinetics of the cathode material and reducing the capacity and rate performance of the cathode material.

In some embodiments, the cathode material exhibits a pH satisfying 11.0$\leq$pH$\leq$12.5, which may specifically be 11.0, 11.2, 11.3, 11.5, 11.8, 12.0, 12.3, or 12.5, etc., which is not limited herein. Controlling the pH of the cathode material within the above range is beneficial to improvement of the processability of the cathode material.

In some embodiments, the cathode material has a mass content of LiOH accounting for 100 ppm<$m_{LiOH}$$\leq$1500 ppm, which may specifically be 110 ppm, 150 ppm, 200 ppm, 300 ppm, 400 ppm, 500 ppm, 600 ppm, 700 ppm, 800 ppm, 900 ppm, 1000 ppm, 1100 ppm, 1200 ppm or 1500 ppm, etc., which is not limited herein. The cathode material has a mass content of $Li_2CO_3$ accounting for 100 ppm<$m_{Li2CO3}$$\leq$5000 ppm, which may specifically be 110 ppm, 200 ppm, 300 ppm, 400 ppm, 500 ppm, 800 ppm, 1000 ppm, 1500 ppm, 2000 ppm, 3000 ppm, 4000 ppm, 4500 ppm or 5000 ppm, etc., which is not limited herein. It can be understood that the alkaline impurities on the surface of the cathode material are mainly $Li_2CO_3$ and LiOH. Controlling the content of LiOH and $Li_2CO_3$ on the surface of the cathode material within the above ranges relieves the corrosion effect of the alkaline impurities on the cathode material, protecting the structural stability of the cathode material, thereby facilitating improvement of the cycle stability of the cathode material.

In some embodiments, the cathode material has a mass content of free lithium accounting for 100 ppm<$m_{Li}$$\leq$2000 ppm, which may specifically be 110 ppm, 200 ppm, 300 ppm, 400 ppm, 500 ppm, 800 ppm, 1000 ppm, 1500 ppm or 2000 ppm, etc., which is not limited herein.

In some embodiments, the cathode material has a specific surface area of 0.5 m$^2$/g to 1.5 m$^2$/g, which may specifically be 0.5 m$^2$/g, 0.6 m$^2$/g, 0.72 m$^2$/g, 0.83 m$^2$/g, 1.01 m$^2$/g, 1.14 m$^2$/g, 1.27 m$^2$/g, 1.38 m$^2$/g, 1.45 m$^2$/g, etc., or other value within the above range, which is not limited herein. By controlling the specific surface area of the cathode material within the above range, the cathode material exhibits higher capacity, initial Coulombic efficiency, and cycle stability, as well as lower gas production.

In some embodiments, the cathode material has a tap density of 1.5 g/cm$^3$ to 3.0 g/cm$^3$, which may specifically be 1.5 g/cm$^3$, 1.6 g/cm$^3$, 1.7g/cm$^3$, 1.8 g/cm$^3$, 1.9 g/cm$^3$, 2.0 g/cm$^3$, 2.1 g/cm$^3$, 2.2 g/cm$^3$, 2.4 g/cm$^3$, 2.5 g/cm$^3$, 2.8 g/cm$^3$ or 3.0 g/cm$^3$, etc., or other value within the above range, which is not limited herein. Controlling the tap density of the cathode material within the above range is beneficial to improving the processability of the material and increasing the energy density of the battery.

In some embodiments, the cathode material has a compaction density of 2.5 g/cm$^3$ to 4.0 g/cm$^3$, which may specifically be 2.5 g/cm$^3$, 2.6 g/cm$^3$, 2.7 g/cm$^3$, 2.8 g/cm$^3$, 2.9 g/cm$^3$, 3.0 g/cm$^3$, 3.1 g/cm$^3$, 3.2 g/cm$^3$, 3.4 g/cm$^3$, 3.5 g/cm$^3$, 3.8 g/cm$^3$ or 4.0 g/cm$^3$, etc., or other value within the above range, which is not limited herein. Controlling the compaction density of the cathode material within the above range is beneficial to increasing the energy density of the battery.

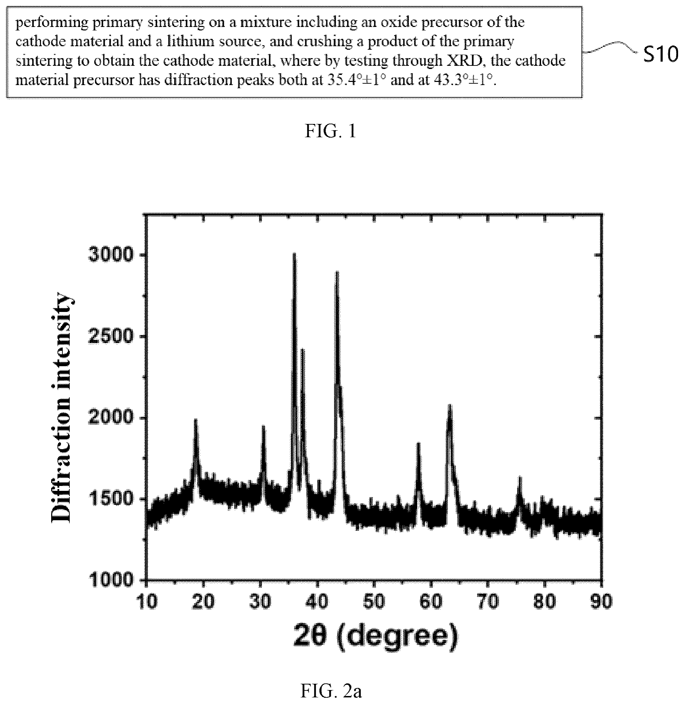

In a second aspect, some embodiments of the present disclosure provide a preparation method of the cathode material, as shown in FIG. 1. The preparation method of the cathode material precursor includes the following steps: performing primary sintering on a mixture including an oxide precursor of the cathode material and a lithium source, and crushing a product of the primary sintering to obtain the cathode material, where by testing through XRD ray, the oxide precursor of the cathode material has diffraction peaks both at $35.4°\pm1°$ and at $43.3°\pm1°$.

In the preparation method of the cathode material provided by the present disclosure, the adopted cathode material precursor has diffraction peaks both at $35.4°\pm1°$ and at $43.3°\pm1°$. Where, the diffraction peak at $43.3°\pm1°$ indicates that a portion of the particles in the cathode material precursor exhibit rock-salt phase, such as NiO in the rock-salt phase; the diffraction peak at $35.4°\pm1°$ indicates that a portion of particles in the cathode material precursor exhibit spinel phase, such as $NiMn_2O_4$. The precursor particles in the rock-salt phase tend to nucleate and grow into particles with a relatively large particle size during the sintering together with lithium salt, resulting in the sintered particles with a high nickel content and a relatively large maximum diameter, while the crystal structure thereof is more stable, allowing to withstand higher nickel content without structural collapse. The precursor particles in the spinel phase have a high nucleation energy barrier during the sintering together with lithium salt, resulting in the sintered particles with a relatively small particle size, a relatively small maximum diameter and a low nickel content, reducing the possibility of lattice defect and oxygen precipitation caused by the Ni mixing, thereby reducing the side reaction on the surfaces of the particles. Therefore, for the cathode material prepared by sintering the above precursor, the structural stability of the material is effectively improved, the particle collapse is reduced, and the cycle performance and capacity retention of the material are improved.

The preparation method of the present disclosure is described below with reference to the embodiments: performing primary sintering on a mixture of an oxide precursor and a lithium source, and crushing a product of the primary sintering to obtain the cathode material, where by testing through XRD ray, the oxide precursor of the cathode material has diffraction peaks both at $34.4°$ to $36.4°$ and at $42.3°$ to $44.3°$.

In some embodiments, the oxide precursor of the cathode material includes NiO and $NiMn_2O_4$.

In some embodiments, the method further includes: annealing a hydroxide precursor of the cathode material at $500°C$ to $900°C$ for 4 h to 12 h to dehydrate the hydroxide to form an oxide, to obtain the oxide precursor of the cathode material, where the oxide precursor has a chemical formula of $Ni_aM_bMn_cO$, where $0<a<1$, $0\leq b<1$, $0<c<1$, $a+b+c=1$, and M is selected from Co and/or Al.

In some embodiments, the annealing is performed at a temperature of $500°C$ to $900°C$, which may specifically be $500°C$, $550°C$, $580°C$, $600°C$, $630°C$, $650°C$, $680°C$, $700°C$, $750°C$, $780°C$, $800°C$, $850°C$ or $900°C$, and the annealing has a duration of 4 h, 5 h, 6 h, 7 h, 8 h, 9 h, 10 h, 11 h or 12 h, etc., or other values within the above ranges, which are not limited herein.

In some embodiments, the lithium source includes at least one of lithium hydroxide, lithium carbonate, lithium nitrate, lithium acetate, lithium sulfate and lithium oxalate. Preferably, the lithium salt is lithium carbonate.

In some embodiments, addition amounts of the lithium source and the cathode material precursor satisfy that a ratio of a molar amount of Li and a total molar amount of all metals in the cathode material precursor is (0.87 to 1.25):1, which may specifically be 0.87:1, 0.89:1, 0.92:1, 0.95:1, 0.98:1, 1.02:1, 1.05:1, 1.1:1, 1.17:1, 1.25:1, etc., or other value within the above range, which is not limited herein. Within this range, the degree of Li/Ni cations mixing is reduced, and excessive residual lithium on the surface of the sintered product is prevented from affecting the processing performance and safety performance.

In some embodiments, the mixture further includes a metal M2-containing dopant, where the M2 metal includes at least one of Zr, Mg, Ti, Ba, Sr, Cr, Zn, V, Cu, Nb, Mo, Y, and W, which may specifically be a salt containing the metal M2 or an oxide containing the metal M2.

In some embodiments, the dopant includes at least one of $Nb_2O_5$, $Nb_2O_3$, $MoO_3$, $WO_2$, $WO_3$, $V_2O_5$, $V_2O_3$, $Sr(OH)_2$, $SrO$, $TiO_2$, $ZrO_2$, $Zr(OH)_4$, $Y_2O_3$, $BaO$, $Cr_2O_3$, $ZnO$, $CuO$, $MgO$ and $Mg(OH)_2$. Preferably, the metal M2-containing dopant is a compound of Zr or Ti.

In some embodiments, a mixing requirement for obtaining the mixture is that: solid phase mixing at $10°C$ to $50°C$ for 0.3 h to 3 h.

In some embodiments, the solid phase mixing is performed at a temperature of $10°C$, $15°C$, $20°C$, $25°C$, $30°C$, $35°C$, $40°C$, $45°C$ or $50°C$, and the solid phase mixing has a duration of 0.3h, 0.4 h, 0.5 h, 0.6 h, 0.8 h, 1 h, 1.5 h, 1.8 h, 2.5 h, or 3 h, etc., or other values within the above ranges, which are not limited herein. Preferably, the solid phase mixing is performed at a temperature of $10°C$ to $35°C$.

In some embodiments, addition amounts of the dopant and the cathode material precursor satisfy that: a ratio of a molar amount of M2 and a total molar amount of metals in the cathode material precursor is (0.01 to 0.04):1, which may specifically be 0.01:1, 0.02:1, 0.03:1, 0.04:1, etc., or other value within the above range, which is not limited herein.

In some embodiments, the solid phase mixing is performed by dry grinding, ball milling, etc., which is not limited herein, as long as the components are uniformly mixed.

In some embodiments, a mixing device is at least one of a ball mill, a three-dimensional mixer, a high-speed mixer, and a VC mixer.

In some embodiments, the primary sintering is performed in an oxygen-containing atmosphere, and a content of oxygen in the oxygen-containing atmosphere is ≥95%.

In some embodiments, the primary sintering is performed at a temperature of 700°C to 1000°C, which may specifically be 700°C, 710°C, 720°C, 730°C, 740°C, 750°C, 780°C, 800°C, 850°C, 900°C or 1000°C, etc., but is not limited to the recited values, and other unrecited value within the numerical range is also applicable. Within this range, sufficient air promotes oxidation of divalent nickel to trivalent nickel, thereby reducing the Li/Ni cation mixing.

In some embodiments, the primary sintering has a holding time of 6 h to 48 h, which may specifically be 6 h, 8 h, 10 h, 12 h, 15 h, 18 h, 24 h, 36 h or 48 h, etc., but is not limited to the recited values, and other unrecited value within the numerical range is also applicable.

In some embodiments, when the metal M-containing dopant is the compound of Zr or Ti, the primary sintering is performed at a temperature of 800°C to 900°C for a holding time of 8 h to 10 h.

In some embodiments, the method further includes: mixing a matrix material obtained by crushing and a metal M3-containing coating agent, and performing secondary sintering to obtain the cathode material.

In some embodiments, the matrix material obtained by crushing has a median particle size of 2.5 $\mu$m to 4.5 $\mu$m.

In some embodiments, the matrix material obtained by crushing has a particle size distribution width satisfying $1.1 \leq (D_{90}-D_{10})/D_{50} \leq 1.7$, which may specifically be 1.1, 1.2, 1.3, 1.4, 1.5, 1.6, 1.7, etc., which is not limited herein. The matrix material has a wider particle size distribution, which is beneficial to increasing stacking tightness of the cathode material, thereby improving the specific capacity of the cathode material.

In some embodiments, a process for crushing includes being performed by at least one of a pair roller, a plow knife mixer/crusher, and an airflow crusher.

In some embodiments, for the metal M3-containing coating agent, the M3 is at least one selected from Zr, Mg, Ti, Ba, Sr, Cr, Zn, V, Cu, Nb, Mo, Y, and W. The metal M3-containing coating agent is a salt or oxide of metal M3. Preferably, the metal M3-containing coating agent includes a compound of Nb and/or a compound of W.

In some embodiments, the secondary sintering is performed in an oxygen-containing atmosphere, and a content of oxygen in the oxygen-containing atmosphere is ≥95%.

In some embodiments, the secondary sintering is performed at a temperature of 300°C to 800°C, which may specifically be 300°C, 320°C, 330°C, 350°C, 380°C, 400°C, 450°C, 500°C, 550°C, 650°C, 700°C or 800°C, etc., but is not limited to the recited numerical values, and other numerical value not recited within the numerical range is also applicable.

In some embodiments, the secondary sintering has a holding time of 6 h to 24 h, which may specifically be 6 h, 8 h, 10 h, 12 h, 15 h, 18 h or 24 h, etc., but is not limited to the recited values, and other unrecited value within the numerical range is also applicable.

In some embodiments, when the metal M3-containing coating agent includes the compound of Nb and/or the compound of W, the secondary sintering is performed at a temperature of 500°C to 600°C for a holding time of 6 h to 8 h.

In some embodiments, the preparation method further includes cooling, shaping and sieving a product of the secondary sintering. The shaping includes at least one of crushing, grinding, ball milling, or gas crushing.

In some embodiments, the sieving adopts a sieve with 300 to 400 mesh.

In a third aspect, embodiments of the present disclosure provide a battery. The battery includes the aforementioned cathode material or the cathode material prepared by the aforementioned preparation method.

The above are only preferred embodiments of the present disclosure and are not intended to limit the present disclosure, and it should be noted herein that any modifications, equivalent substitutions, improvements, and the like made within the spirit and principle of the present disclosure shall fall within the protection scope of the present disclosure.

The present disclosure is further described below by multiple embodiments. The embodiments herein are not limited to the specific embodiments described below. Variations may be made as appropriate within the scope of the independent claims.

**Test Method:**

**(1) Molar Content Test of Main Elements (Li/Ni/M/Mn) of the Precursor and the Cathode Material**

Equipment: Agilent 5110 ICP-OES Plasma Inductively Coupled Tester.
Method: 0.3 g of sample was taken and added with aqua regia for digestion, after cooling and constant volume, 1 mL of the digestion solution was taken and 100-fold diluted to test the mass contents of main elements Li/Ni/M/Mn. Their molar contents were obtained by conversion of the mass contents.

**(2) Diffraction Peaks Characterization of XRD of the Cathode Material Precursor**

Equipment: X-ray diffraction tester of X'Pert Powder or Bruker.

Method: a powder sample was filled into a sample groove, and its upper surface was flattened by a glass sheet to ensure that the upper surface of the sample was parallel to the groove edge. The scanning range was $2\theta$=10-90°C, and the total scanning duration was not less than 5 minutes. After the scanning was completed, the position and height of the diffraction peaks were identified by opening with jade software and automatically finding peaks through Analyswas → Find Peaks.

**(3) Alkaline Impurities Test for the Cathode Material:**

5.0 g of cathode material powder was immersed in 100 mL of deionized water and stirred in a sealed glass flask for 10 minutes. After sufficient stirring, the suspension was filtered to obtain a clear solution. Then, 90 mL of the clear solution was titrated by recording the pH curve while adding 0.1 mol/L of HCl solution at a rate of 0.5 mL/min with stirring, until the pH reached to be 3. The reference voltage curves were obtained by titration of LiOH and $Li_2CO_3$ with low concentrations dissolved in the deionized water. The first plateau with endpoint y1 (in mL) at pH = 8 to 9 was for determining the mass content of $OH^-/H_2O$, and the second plateau with endpoint y2 (in mL) at pH = 4 to 6 was for determining the mass content of $HCO_3^-/H_2CO_3$. The inflection point y1 between the first plateau and the second plateau and the inflection point y2 after the second plateau were obtained from respective minima of the derivative dpH/dVol of the pH curve. The results were then expressed in weight percentages of LiOH, $Li_2CO_3$ and Free Li, as shown in formula (3), (4) and (5) below:

$$Li_2CO_3\text{wt}\% = \frac{73.89}{1000} \times (y2 - y1) \qquad (3)$$

$$LiOH\text{wt}\% = \frac{23.95}{1000} \times (2y1 - y2) \qquad (4)$$

$$Free\ Li\text{wt}\%=LiOH\text{wt}\%*6.94/23.95+Li_2CO_3\text{wt}\%*6.94*2/73.89 \qquad (5).$$

**(4) pH Characterization of the Cathode Material:**

about 5 g of the cathode material sample was taken, 45 mL of water was added, and treated by sonication for 5 min, then taken out and stood for 10 min. After calibration of pH meter, the composite electrode was inserted into the supernatant to be tested. The pH value of the solution was calculated from the potential difference between the measurement electrode and the reference electrode.

**(5) Test Method of Median Volume Particle Size of the Cathode Material:**

the particle size volume distribution of the cathode material was tested by a Malvern laser particle size analyzer to obtain the median particle size $D_{50}$.

**(6) Test Method of Specific Surface Area of Cathode Material:**

Equipment: the specific surface area of the cathode material was tested by a Tristar 3020 type surface area and pore size analyzer of Micromeritics.

Method: the mass of the empty sample tube was weighted as m1. 3 g of sample was taken and added into the sample tube through a long-neck funnel; vacuum degassing was performed at 300°C for 1 h, after cooling, the mass of the sample tube was weighted as m2; and the mass of the sample was m=m2-m1. The sample tube was placed in liquid nitrogen, and the nitrogen adsorption amount V of the sample was measured under a series of relative pressures P/P0 to obtain an adsorption isotherm. P/P0 was set to 0.05/0.1/0.15/0.20/0.25/0.30. The adsorption isotherm was fitted, the single-layer saturated adsorption capacity Vm was calculated depending on the slope and intercept, and the specific surface area was calculated depending on Vm.

**(7) Quantachrome Tap Density Test of the Cathode Material:**

Equipment: Tap Density analyzer of Quantachrome, USA (model: DAT-4-220),

Method: a measuring cylinder was cleaned, and then its mass was weighed as m1; about 50 g of sample was added into the measuring cylinder, enabling the surface of the sample to be horizontal as much as possible, and the periphery was wiped with paper towels. The total mass of the sample and the measuring cylinder was weighed as m2. The measuring cylinder was placed on a vibrating platform, and fixed with three symmetrical fixing feet. The instrument was activated, and the number of vibration was set to be 5000 times. The vibration switch was turned on, and the instrument automatically shut down once vibrations reached the preset count. The measuring cylinder was taken out, and the volume of the sample was read. If the surface of the tapped sample was horizontal, the volume was directly read; if it was in a diagonal state, the average value V of the readings of the highest point and the lowest point was taken. The tap density=(m2-m1)/V.

**(8) Compaction Density Test of the Cathode Material:**
the compaction density of the cathode material was tested by carver 4350, USA. The step is that: 1 g of sample was weighed and placed into a mold, and pressed for 30 s under a pressure of 3T. After the pressing, the height was tested to calculate the compaction.

**(9) Average Particle Size Test of the Cathode Material:**
a section SEM test was performed on the cathode material. An image with a magnification factor of 3000 times was selected, and the particle sizes of all the primary particles were measured for the maximum diameter of the particles through a Nano Measure software. After all the particles in the image were measured, the maximum diameters of all the first particles with the maximum diameters smaller than 1.5 $\mu$m were counted and averaged to obtain the average particle size of the first particle; and the maximum diameters of all the second particles with the maximum diameters larger than 2.5 $\mu$m were counted and averaged to obtain the average particle size of the second particle. The maximum diameters of all particles in the image were averaged to obtain the average particle size of the cathode material.

**(10) SEM and EDS Characterization of the Cathode Material:**

Equipment: Hitachi S4800 scanning electron microscope, Energy Dispersive Spectrometer of OXFORD Instrument.

SEM Test Method: when the powder sample was tested, a tool such as a tweezer was used for sticking the powder sample, laying it on the conductive adhesive and flattening, and the test was performed under the electron beam condition of 5kV/10 mA. When the section sample was tested, the material was coated on an aluminum foil by a conventional electrode preparation process, cut by a focused ion beam (FIB), and tested under the same conditions as the powder sample by SEM.

EDS Test Method: the electron beam voltage of the SEM was adjusted to 15 kV or more, and then the EDS was used for selective region test, where the selective region range was the central part of each single-crystal particles. When calculating the average value of the ratio of Ni/Mn elements, it needs to select 10 particles with the maximum diameter less than 1.5 $\mu$m (i.e., the first particles) and 10 particles with the maximum diameter greater than 2.5 $\mu$m (i.e., the second particles) for EDS testing respectively to obtain the Ni/Mn ratios of the 10 first particles and the Ni/Mn ratios of the 10 second particles respectively. Both of the maximum value and the minimum value were removed from the obtained Ni/Mn ratios of the 10 first particles, and then the remaining 8 values were averaged to obtain R1. Both of the maximum value and the minimum value were removed from the obtained Ni/Mn ratios of the 10 second particles, and then the remaining 8 values were averaged to obtain R2.

**(11) Test Method of The $SO_4{}^{2-}$ Content of the Cathode Material:**
Test Method of the $SO_4{}^{2-}$ Content: the sample solution was pretreated, separated by an ion chromatography column, and underwent a quantitative analysis for the relationship between the concentration of the separated sulfate ions and the detection signal. The conductivity detector was commonly used as a detection means for ion chromatography, which determined the concentration of sulfate ions by monitoring changes in conductivity. The test results are shown in Table 2.

**(12) Electrochemical Performance Test:**

assembling the cathode materials obtained by the Examples and Comparative Examples into button batteries: the cathode material, conductive carbon and polyvinylidene fluoride (PVDF) in a mass ratio of 96:2:2 were added to N-methyl-2 pyrrolidone (NMP), uniformly mixed to prepare a cathode slurry, and coated on a cathode current collector and dried in vacuum to form a cathode plate (the compaction density of the plate is: 2.8 g/cm$^3$). A lithium sheet was further adopted as an anode plate, and a 2016-button battery was assembled in a glove box.

At a discharge interval of 3.0V to 4.3V and with a theoretical capacity of 1C of 250 mAh/g, a CT2001A type battery detection system of Wuhan LAND Electronics Co., Ltd. was used for testing. The test results are shown in Table 3.

**(13) Orientation Test of the Primary Particles of the Crystal Grain:**

Equipment: an electron backscatter diffractometer (EBSD) mounted on a scanning electron microscope, type: Gemini SEM300.

Method: the color of single primary particles in a crystal grain was observed to determines whether the crystal grain contains a single grain in which all the primary particles exhibiting identical orientation. When the color of all the primary particles in the crystal grain was the same, it was determined that all the primary particles in the crystal grain exhibited identical orientation.

**Example 1**

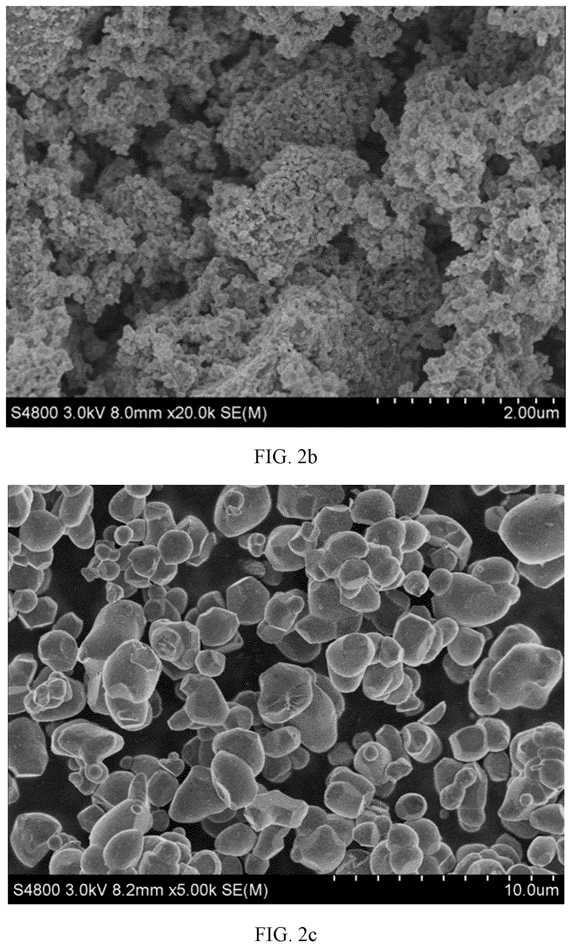

(1) an oxide precursor of a cathode material prepared by a pyrolysis method was selected, with a chemical formula of $Ni_{0.6}Co_{0.1}Mn_{0.3}O_x$ (the molar content deviations of each main elements were within $\pm 1\%$), as shown in Table 1. By characterizing through XRD ray, as shown in FIG. 2a, the cathode material precursor has diffraction peaks both at 35.9° and at 43.4°. As shown in FIG. 2b, the cathode material precursor exhibits a morphology of secondary particles formed by agglomeration of a plurality of primary particles.

(2) the cathode material precursor and $Li_2CO_3$ were mixed in a molar ratio of Li/Me (Me is a sum of molar contents of elements Ni, Co, and Mn) of 1.02:1, added with $TiO_2$ having a mass content of 2000 ppm relative to the cathode material precursor, and performed primary sintering at 900°C for 10 h in an oxygen atmosphere.

(3) the product of the primary sintering was crushed by a plough crusher for 30 s to obtain a matrix material.

(4) the matrix material was mixed with 1000 ppm of $Nb_2O_5$, and performed secondary sintering at 500°C for 6 h in an oxygen atmosphere. Then, product of the secondary sintered was sieved through a sieve with 325 mesh to obtain the cathode material.

As shown in FIG. 2c, the cathode material prepared by this Example of the present disclosure exhibits a morphology of rounded spherical single particles, and has less cross section caused by crushing on the surface.

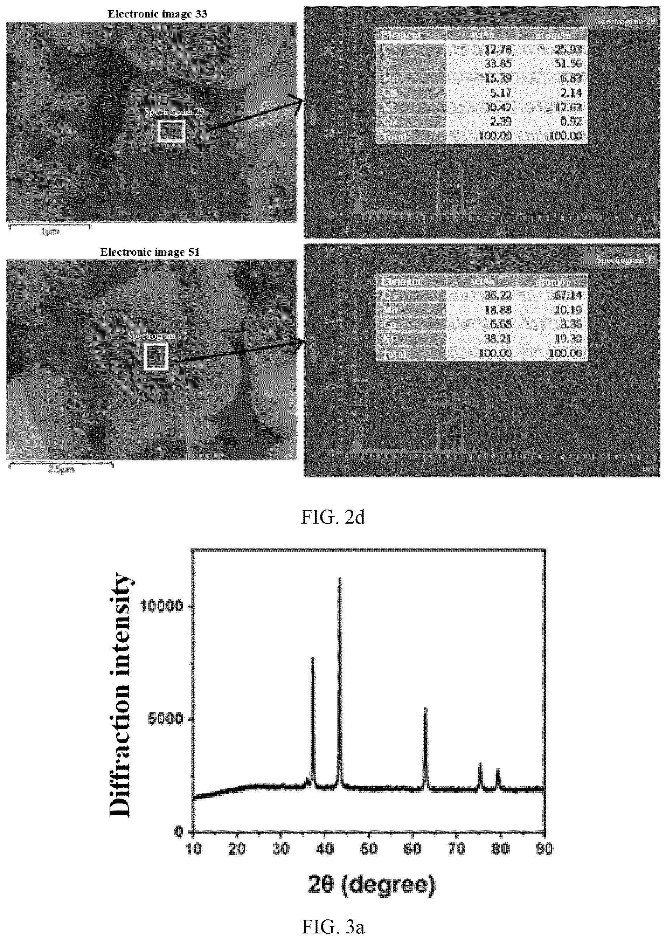

The characterization results of section SEM and EDS show that, as shown in FIG. 2d, the 10 Ni/Mn ratios of the first particles within the particle size range of $\leq 1.5$ μm are respectively 1.85, 1.87, 1.90, 1.79, 1.85, 1.91, 1.90, 1.89, 1.91 and 1.79, and thus the R1 is 1.87 obtained by removing the maximum value and the minimum value and averaging; and the 10 Ni/Mn ratios of the second particles within the particle size range of $\geq 2.5$ μm are respectively 1.83, 1.87, 1.86, 1.88, 1.96, 1.91, 1.92, 1.89, 1.87 and 1.94, and thus the R2 is 1.89 obtained by removing the maximum value and the minimum value and averaging. The remaining test results are shown in Table 2.

**Example 2**

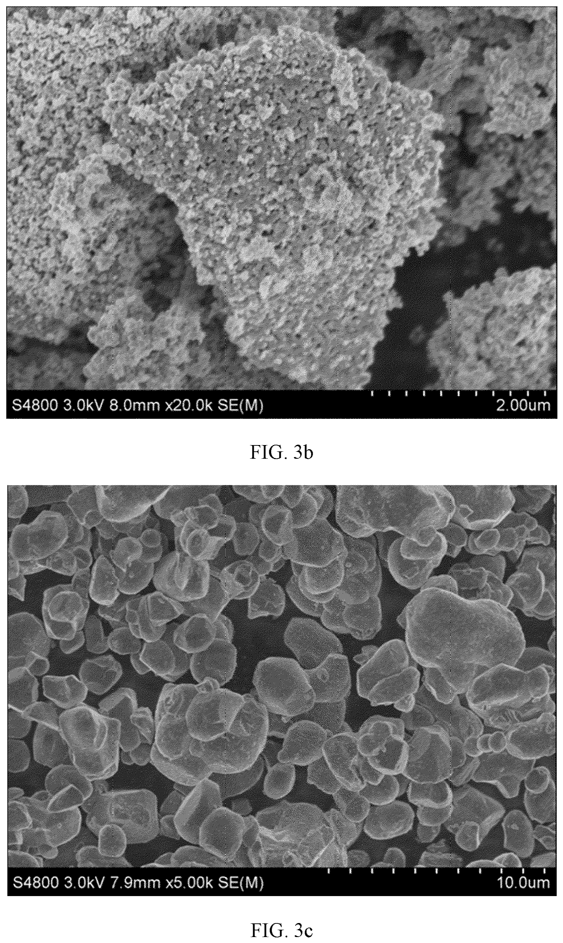

(1) an oxide precursor of a cathode material prepared by a pyrolysis method was selected, with a chemical formula of $Ni_{0.9}Co_{0.05}Mn_{0.05}O_x$ (the molar content deviations of each main elements were within $\pm 1\%$), as shown in Table 1. By characterizing through XRD ray, as shown in FIG. 3a, the cathode material precursor has diffraction peaks both at 35.9° and at 43.3°. As shown in FIG. 3b, the cathode material precursor exhibits a morphology of secondary particles formed by agglomeration of a plurality of primary particles.

(2) the cathode material precursor and $Li_2CO_3$ were mixed in a molar ratio of Li/Me (Me is a sum of elements Ni, Co, and Mn) of 1.01:1, added with $TiO_2$ having a mass content of 2000 ppm relative to the cathode material precursor, and performed primary sintering at 800°C for 8 h in an oxygen atmosphere. The reason why the temperature for the sintering was lower than that in Example 1 is that the Ni content is higher, and according to the characteristics of the ternary material, the temperature for the sintering should be inversely proportional to the Ni content in order to ensure similar crystal grain sizes.

(3) the product of the primary sintering was crushed by a plough crusher for 30 s to obtain a matrix material.

(4) the matrix material was mixed with 2000 ppm of $WO_3$, and performed secondary sintering at 550°C for 8 h in an oxygen atmosphere. Then, product of the secondary sintered was sieved through a sieve with 325 mesh to obtain the cathode material.

As shown in FIG. 2c, the cathode material prepared by this Example of the present disclosure exhibits a morphology of rounded spherical single particles, and has less cross section caused by crushing on the surface.

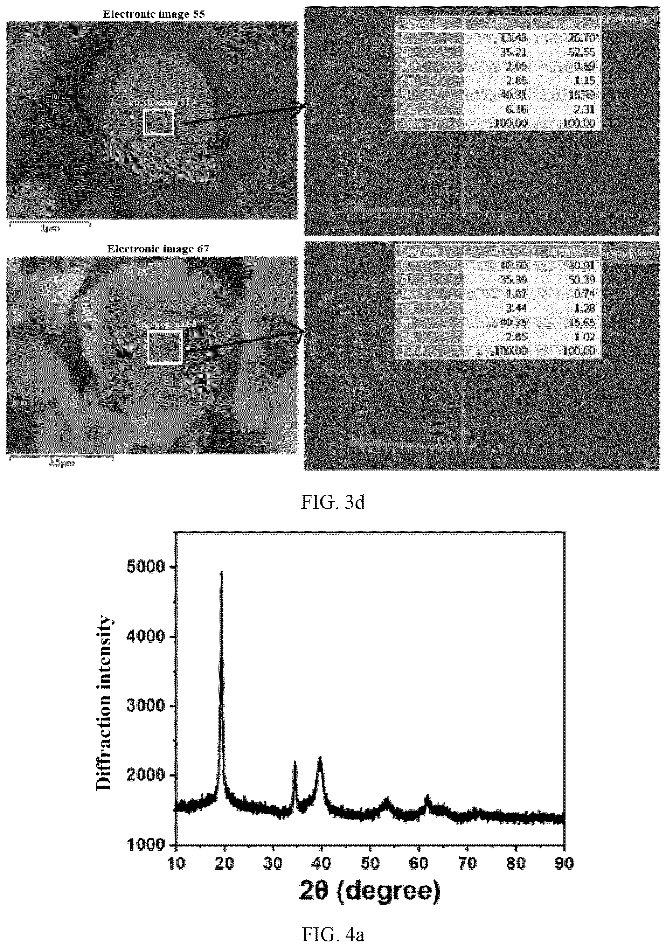

The characterization results of section SEM and EDS show that, as shown in FIG. 3d, the 10 Ni/Mn ratios of the first particles within the particle size range of $\leq 1.5$ μm are respectively 19.05, 19.59, 18.42, 19.02, 23.66, 21.32, 20.37, 20.51, 19.64, and 17.60, and thus the R1 is 19.74 obtained by removing the maximum value and the minimum value and averaging; and the 10 Ni/Mn ratios of the second particles within the particle size range of $\geq 2.5$ μm are respectively 19.55, 19.04, 15.59, 22.68, 19.15, 19.17, 18.17, 20.65, 21.54, and thus the R2 is 19.80 obtained by removing the maximum value and the minimum value and averaging. The remaining test results are shown in Table 2.

**Example 3**

This example was conducted in the same way as Example 1 excepting that:

(1) an oxide precursor of a cathode material prepared by a pyrolysis method was selected, with a chemical formula of $Ni_{0.67}Co_{0.05}Mn_{0.28}O_x$ (the molar content deviations of each main elements were within $\pm 1\%$), as shown in Table 1. Moreover, the cathode material precursor also contained 85 ppm of Ca.

**Example 4**

This example was conducted in the same way as Example 1 excepting that:
(4) the matrix material was mixed with 1000 ppm of $ZrO_2$, and performed secondary sintering at 850°C for 8 h in an oxygen atmosphere. Then, product of the secondary sintered was sieved through a sieve with 325 mesh to obtain the cathode material.

**Example 5**

This example was conducted in the same way as Example 2 excepting that:
(4) the matrix material was mixed with 1000 ppm of $WO_3$, and performed secondary sintering at 880°C for 8 h in an oxygen atmosphere. Then, product of the secondary sintered was sieved through a sieve with 325 mesh to obtain the cathode material.

**Example 6**

This example was conducted in the same way as Example 3 excepting that:
(4) the matrix material was mixed with 1000 ppm of MgO, and performed secondary sintering at 960°C for 8 h in an oxygen atmosphere. Then, product of the secondary sintered was sieved through a sieve with 325 mesh to obtain the cathode material.

**Example 7**

This example was conducted in the same way as Example 1 excepting that:
(4) the matrix material was mixed with 1000 ppm of $WO_3$, and performed secondary sintering at 920°C for 12 h in an oxygen atmosphere. Then, product of the secondary sintered was sieved through a sieve with 325 mesh to obtain the cathode material.

**Example 8**

This example was conducted in the same way as Example 1 excepting that:
the step (4) was not performed.

**Example 9**

This example was conducted in the same way as Example 2 excepting that:

(1) an oxide precursor of a cathode material prepared by a pyrolysis method was selected, with a chemical formula of $Ni_{0.92}Al_{0.02}Mn_{0.06}O_x$ (the molar content deviations of each main elements were within $\pm 1\%$).

**Example 10**

This example was conducted in the same way as Example 1 excepting that:

(1) a hydroxide precursor of $Ni_{0.6}Co_{0.1}Mn_{0.3}(OH)_2$ prepared by a co-precipitation method was selected, annealed at 730°C for 8 h to obtain an oxide precursor of a cathode material with a chemical formula of $Ni_{0.6}Co_{0.1}Mn_{0.3}O_x$ (the molar content deviations of each main elements were within $\pm 1\%$), as shown in Table 1. The prepared cathode material has a sulfate content as high as 830 ppm, leading to that the migration of $Li^+$ is hindered, resulting in that the capacity, rate and capacity of the material are poorer than those of Example 1.

**Example 11**

This example was conducted in the same way as Example 1 excepting that: the temperature for the primary sintering was reduced from 900°C to 820°C.

**Example 12**

This example was conducted in the same way as Example 1 excepting that:

(1) a hydroxide precursor of $Ni_{0.6}Co_{0.1}Mn_{0.3}(OH)_2$ prepared by a sol-gel method was selected, annealed at 600°C for 4 h to obtain an oxide precursor of a cathode material with a chemical formula of $Ni_{0.6}Co_{0.1}Mn_{0.3}O_x$ (the molar content deviations of each main elements were within $\pm 1\%$). The prepared cathode material has a sulfate content as high as 1240 ppm.

**Example 13**

This example was conducted in the same way as Example 1 excepting that: (1) an oxide precursor of a cathode material prepared by a pyrolysis method was selected, with a chemical formula of $Ni_{0.34}Co_{0.33}Mn_{0.33}O_x$ (the molar content deviations of each main elements were within $\pm 1\%$), as shown in Table 1.

**Example 14**

This example was conducted in the same way as Example 1 excepting that: (1) an oxide precursor of a cathode material prepared by a pyrolysis method was selected, with a chemical formula of $Ni_{0.45}Co_{0.25}Mn_{0.30}O_x$ (the molar content deviations of each main elements were within $\pm 1\%$), as shown in Table 1.

**Example 15**

This example was conducted in the same way as Example 1 excepting that: it was different from Example 1 in that: (1) an oxide precursor of a cathode material prepared by a pyrolysis method was selected, with a chemical formula of $Ni_{0.55}Co_{0.12}Mn_{0.33}O_x$ (the molar content deviations of each main elements were within $\pm 1\%$), as shown in Table 1.

**Example 16**

This example was conducted in the same way as Example 1 excepting that: it was different from Example 1 in that: (1) an oxide precursor of a cathode material prepared by a pyrolysis method was selected, with a chemical formula of $Ni_{0.83}Co_{0.08}Mn_{0.09}O_x$ (the molar content deviations of each main elements were within $\pm 1\%$), as shown in Table 1.

**Comparative Example 1**

This comparative example was conducted in the same way as Example 1 excepting that:

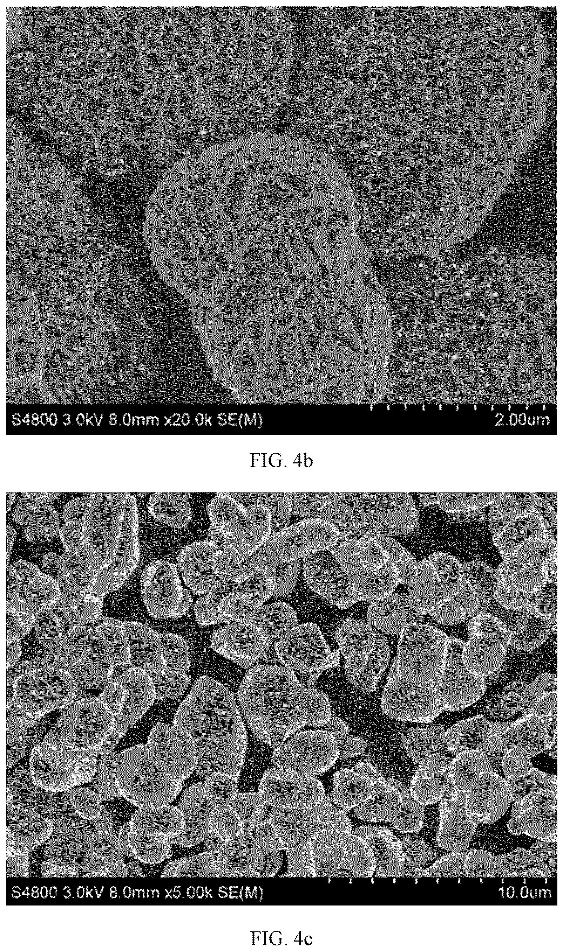

(1) an oxide precursor of a cathode material prepared by a conventional co-precipitation method was selected, with a chemical formula of $Ni_{0.6}Co_{0.1}Mn_{0.3}O_x$ (the molar content deviations of each main elements were within $\pm 1\%$), as shown in Table 1. By characterizing through XRD ray, as shown in FIG. 4a, the cathode material precursor has a diffraction peak at 19.3°, but no diffraction peak at 35.4° or 43.3°. As shown in FIG. 4b, the cathode material precursor exhibits a morphology of secondary particles formed by agglomeration of a plurality of primary particles.

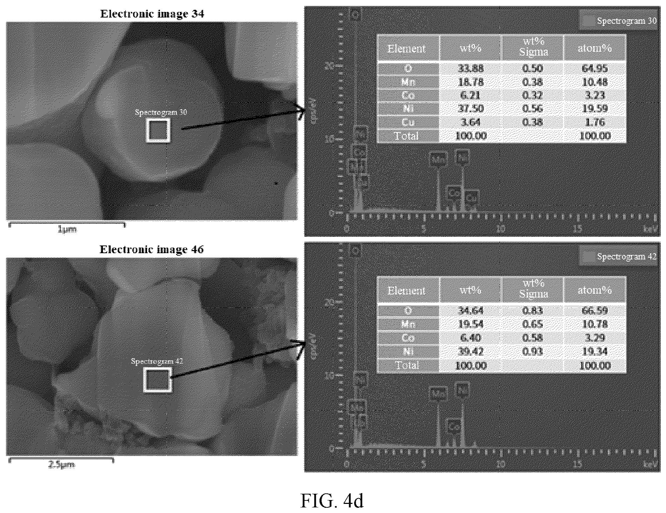

As shown in FIG. 4c, the cathode material exhibits a morphology of a single-crystal particles with relatively clear angles, and cross sections caused by crushing on the surface are observed. The characterization results of section SEM and EDS of the cathode material show that, as shown in FIG. 4d, the 10 Ni/Mn ratios of the first particles within the particle size range of $\leq 1.5\ \mu m$ are respectively 1.86, 1.89, 1.90, 1.89, 1.86, 1.92, 1.81, 1.88, 1.92, and 1.93, and thus the R1 is 1.89 obtained by removing the maximum value and the minimum value and averaging; and the 10 Ni/Mn ratios of the second particles within the particle size range of $\geq 2.5\ \mu m$ are respectively 1.80, 1.79, 1.86, 1.86, 1.97, 1.88, 1.85, 1.75, 1.87, 1.97, and thus the R2 is 1.86 obtained by removing the maximum value and the minimum value and averaging.

**Comparative Example 2**

This comparative example was conducted in the same way as Example 2 excepting that:

(1) an oxide precursor of a cathode material prepared by a conventional co-precipitation method was selected, with a chemical formula of $Ni_{0.9}Co_{0.05}Mn_{0.05}O_x$ (the molar content deviations of each main elements were within $\pm 1\%$), as shown in Table 1. By characterizing through XRD ray, the cathode material precursor has a diffraction peak at 19.3°, but no diffraction peak at 35.4° or 43.3°.

**Comparative Example 3**

This comparative example was conducted in the same way as Example 3 excepting that:

(1) an oxide precursor of a cathode material prepared by a conventional co-precipitation method was selected for ICP characterization, with a chemical formula of $Ni_{0.67}Co_{0.05}Mn_{0.28}O_x$ (the molar content deviations of each main elements were within $\pm 1\%$), as shown in Table 1. By characterizing through XRD ray, the cathode material precursor has a strong diffraction peak at 19.4°, but no diffraction peak at 35.4° or 43.3°.

Table 1 Comparison Table of the Cathode Materials of Examples and Comparative Examples

| No. | Main Element Contents (mol%) | | | $R_1$ | $R_2$ | $R_2-R_1$ | Residual Alkali (ppm) | | | pH | Speci fic Surfa ce Area $(m^2/g)$ | Tap Dens ity $(g/c\ m^3)$ | Com pacti on Dens ity $g/cm\ 3$ |
|---|---|---|---|---|---|---|---|---|---|---|---|---|---|
| | Ni | M | Mn | | | | LiO H | $Li_2CO_3$ | Lith ium | | | | |
| Example 1 | 0.599 | 0.098 | 0.303 | 1.87 | 1.89 | 0.0 2 | 422 | 948 | 301 | 11.43 | 0.77 | 2.16 | 3.04 |
| Example 2 | 0.901 | 0.050 | 0.049 | 19.74 | 19.80 | 0.06 | 1250 | 1511 | 652 | 11.79 | 0.78 | 1.96 | 3.04 |
| Example 3 | 0.672 | 0.051 | 0.277 | 2.38 | 2.45 | 0.07 | 482 | 804 | 378 | 11.34 | 0.79 | 1.92 | 3.08 |
| Example 4 | 0.601 | 0.099 | 0.300 | 1.77 | 1.99 | 0.22 | 1111 | 4937 | 125 5 | 11.89 | 0.89 | 2.12 | 3.10 |
| Example 5 | 0.942 | 0.029 | 0.029 | 19.62 | 20.03 | 0.41 | 1408 | 3825 | 113 5 | 12.32 | 1.33 | 2.32 | 3.18 |
| Example 6 | 0.669 | 0.049 | 0.282 | 2.26 | 2.43 | 0.17 | 1462 | 1213 | 650 | 11.52 | 1.12 | 1.78 | 2.86 |
| Example 7 | 0.605 | 0.099 | 0.296 | 1.74 | 2.25 | 0.51 | 791 | 938 | 408 | 11.56 | 1.07 | 2.11 | 3.10 |
| Example 8 | 0.601 | 0.099 | 0.300 | 1.78 | 1.86 | 0.08 | 483 | 172 | 474 | 11.53 | 0.85 | 1.83 | 3.00 |
| Example 9 | 0.921 | 0.022 | 0.057 | 20.13 | 20.16 | 0.03 | 1238 | 1482 | 667 | 11.75 | 0.80 | 1.89 | 3.03 |
| Example 10 | 0.600 | 0.105 | 0.295 | 1.85 | 1.90 | 0.05 | 455 | 798 | 365 | 11.51 | 0.84 | 2.05 | 3.08 |
| Example 11 | 0.601 | 0.102 | 0.297 | 1.86 | 1.90 | 0.04 | 254 | 1360 | 382 | 11.39 | 0.57 | 1.62 | 2.95 |
| Example 12 | 0.600 | 0.101 | 0.299 | 1.75 | 1.78 | 0.03 | 341 | 1898 | 456 | 11.49 | 0.89 | 1.77 | 3.00 |
| Example 13 | 0.339 | 0.330 | 0.331 | 1.02 | 1.03 | 0.01 | 266 | 980 | 237 | 11.37 | 0.68 | 2.23 | 3.11 |
| Example 14 | 0.450 | 0.248 | 0.302 | 1.46 | 1.51 | 0.05 | 311 | 830 | 295 | 11.42 | 0.73 | 1.99 | 3.02 |
| Example 15 | 0.552 | 0.121 | 0.327 | 1.67 | 1.70 | 0.03 | 325 | 1120 | 362 | 11.48 | 0.80 | 1.98 | 2.99 |
| Example 16 | 0.831 | 0.079 | 0.090 | 9.25 | 9.30 | 0.05 | 788 | 1468 | 689 | 11.69 | 0.87 | 2.03 | 3.03 |
| Comparativ e Example 1 | 0.599 | 0.098 | 0.303 | 1.89 | 1.86 | -0.03 | 859 | 1588 | 547 | 11.59 | 1.07 | 1.95 | 3.02 |
| Comparativ e Example 2 | 0.899 | 0.051 | 0.050 | 21.89 | 21.68 | -0.21 | 1493 | 1558 | 731 | 11.83 | 1.23 | 1.84 | 3.02 |
| Comparativ e Example 3 | 0.670 | 0.050 | 0.280 | 2.44 | 2.28 | -0.16 | 422 | 1002 | 313 | 11.12 | 0.98 | 1.74 | 2.71 |

Table 2 Comparison Table of the Cathode Materials of Examples and Comparative Examples

| No. | $SO_4^{2-}$ (ppm) | Whether containing a single crystal grain exhibiting identical orientation | Average particle size of the cathode material ($\mu$m) |
|---|---|---|---|
| Example 1 | 621 | Yes | 2.21 |
| Example 2 | 589 | Yes | 2.32 |
| Example 3 | 561 | Yes | 1.89 |
| Example 4 | 685 | Yes | 3.27 |
| Example 5 | 605 | Yes | 4.13 |
| Example 6 | 543 | Yes | 2.76 |
| Example 7 | 525 | Yes | 2.54 |
| Example 8 | 762 | Yes | 1.67 |
| Example 9 | 698 | Yes | 2.41 |
| Example 10 | 710 | Yes | 2.89 |
| Example 11 | 622 | No | 0.89 |
| Example 12 | 1240 | Yes | 2.61 |
| Example 13 | 534 | Yes | 2.11 |
| Example 14 | 678 | Yes | 2.35 |
| Example 15 | 667 | Yes | 2.48 |
| Example 16 | 710 | Yes | 2.66 |
| Comparative Example 1 | 953 | Yes | 2.53 |
| Comparative Example 2 | 962 | Yes | 2.08 |
| Comparative Example 3 | 1152 | Yes | 2.42 |

**Preparation of the Cathode Material**

Each of the cathode material precursors prepared by Examples and Comparative Examples and LiOH were mixed in a molar ratio of 1:1.02, and added with $Al(OH)_3$ with a doping amount of 1600 ppm, $TiO_2$ with a doping amount of 800 ppm, and $Sr(OH)_2$ with a doping amount of 600 ppm for mixing. The mixture was sintered at 730°C for 25 h in an oxygen atmosphere with a concentration of 95%, cooled, crushed and sieved to obtain the cathode material.

Button batteries were assembled for electrochemical testing. The test results are shown in Table 3 below.

Table 3 Comparison Table of the Cathode Materials of Examples and Comparative Examples

| No. | Specific Capacity of the button battery (mAh/g) | | Initial Coulombic Efficiency (%) | Rate Capacity Retention (%) | | | Cycle Retention after 500 cycles (%) | |
|---|---|---|---|---|---|---|---|---|
| | 0.1C Charging | 0.1C Discharging | | 0.5C | 1C | 2C | 1.0C/25°C | 1.0C/45°C |
| Example 1 | 219.8 | 198.0 | 90.1 | 93.79 | 90.74 | 86.94 | 97.54 | 97.29 |
| Example 2 | 254.6 | 228.6 | 89.8 | 93.23 | 90.45 | 86.56 | 96.42 | 97.66 |
| Example 3 | 228.1 | 205.1 | 89.9 | 93.44 | 90.52 | 86.77 | 96.78 | 97.89 |
| Example 4 | 220.0 | 196.7 | 89.4 | 93.17 | 90.22 | 86.13 | 96.04 | 97.33 |
| Example 5 | 252.4 | 227.7 | 90.2 | 92.97 | 90.01 | 85.89 | 95.89 | 96.78 |
| Example 6 | 229.5 | 207.5 | 90.4 | 93.89 | 91.04 | 87.01 | 96.48 | 98.01 |
| Example 7 | 218.9 | 197.3 | 90.1 | 92.89 | 90.90 | 86.44 | 96.67 | 98.25 |
| Example 8 | 219.1 | 196.9 | 89.8 | 92.92 | 90.13 | 86.05 | 95.97 | 97.32 |

(continued)

| No. | Specific Capacity of the button battery (mAh/g) | | Initial Coulombic Efficiency (%) | Rate Capacity Retention (%) | | | Cycle Retention after 500 cycles (%) | |
|---|---|---|---|---|---|---|---|---|
| | 0.1C Charging | 0.1C Discharging | | 0.5C | 1C | 2C | 1.0C/25°C | 1.0C/45°C |
| Example 9 | 253.8 | 227.9 | 89.8 | 93.12 | 90.40 | 86.37 | 96.88 | 97.85 |
| Example 10 | 218.9 | 196.9 | 89.9 | 93.66 | 90.67 | 86.88 | 96.81 | 97.21 |
| Example 11 | 220.1 | 196.4 | 89.2 | 93.88 | 90.81 | 87.08 | 94.23 | 95.12 |
| Example 12 | 219.2 | 195.3 | 89.1 | 93.12 | 90.34 | 86.87 | 94.92 | 96.23 |
| Example 13 | 199.3 | 176.6 | 88.6 | 94.33 | 91.07 | 87.85 | 95.27 | 96.78 |
| Example 14 | 204.1 | 181.2 | 88.8 | 94.04 | 90.88 | 87.56 | 95.03 | 96.56 |
| Example 15 | 211.6 | 188.3 | 89.0 | 93.75 | 90.58 | 87.39 | 94.82 | 96.51 |
| Example 16 | 247.2 | 221.5 | 89.6 | 93.55 | 90.18 | 87.09 | 93.99 | 95.74 |
| Comparative Example 1 | 219.4 | 196.4 | 89.5 | 92.65 | 88.80 | 85.11 | 95.21 | 96.46 |
| Comparative Example 2 | 252.3 | 225.9 | 89.5 | 91.33 | 87.62 | 84.64 | 95.33 | 95.58 |
| Comparative Example 3 | 228.3 | 203.4 | 89.1 | 91.99 | 89.13 | 84.98 | 94.79 | 95.34 |

In the cathode materials provided in Examples 1-7, by making the molar ratios of Ni element and Mn element of the two types of particles of the cathode materials different, the nickel manganese molar ratio of the larger particles is greater than that of the smaller particles. That is, the Ni content of the first particles with the particle size of <1.5 $\mu$m is relatively low, reducing the possibility of lattice defect and oxygen precipitation caused by the Ni mixing, thereby reducing the side reaction on the surface of the particles. On the other hand, the first particles with the particle size of <1.5 $\mu$m have relatively larger specific surface area and higher activity to increase the lithium storage sites, thereby improving the specific capacity of the material. For the cathode material, the specific capacity and the initial efficiency performance of the cathode material are effectively improved, while the structural stability and the cycle performance are also improved.

From the parameter data of the cathode material precursors of Example 1 and Comparative Example 1, it can be seen that due to the using of conventional hydroxide precursor in Comparative Example 1, there was no two phases of spinel phase and rock-salt phase with different Ni contents. Therefore, after sintering, the Ni element distribution does not involve a gradient advantages of being higher in the large particles and lower in the small particles, and the $R_2$-$R_1$ value of the cathode material precursor is less than 0. By comparing with the electrochemical performances of the cathode material prepared by the cathode material precursor, the discharge capacity and the initial Coulombic efficiency of Example 1 are both higher, and the cycle stability at both normal temperature and high temperature also involve obvious advantages. These results show that the single-crystal material lacking Ni gradient distribution has a structure prone to collapse, and in which the Ni mixing causes increased lattice defecs and oxygen precipitation, resulting in slightly reduced structural stability and cycle performance of the cathode material.

Similarly, the comparison between Comparative Example 2 and Example 2, along with Comparative Example 3 and Example 3 is the comparison conducted based on the ternary materials with different Ni/Co/Mn contents, which also indicate that both the higher Ni content in large particles and the lower Ni content in small particles always exhibit the advantages on electrochemical performance in different ternary systems.

In addition, based on the above examples, preferred embodiments can be found by comparing different material parameters caused by different preparation conditions.

From the test data of Examples 1, 4, 7 and 8, it can be seen that all of them are based on the ternary cathode material system with Ni:Co:Mn = 6:1:3, while adopting different doping ingredients during the sintering, which results in a difference in the Ni element distribution, thereby affecting parameters such as particle size, surface residual lithium, tap density, and compaction density, etc. By comparing the electrochemical performances of the cathode materials, it can be seen that the capacity, rate and cycle performance of Example 1 are optimal, indicating that the doping of Nb element is better than the doping of Zr element and W element on the electrochemical performance of the cathode material. The doping of W element results in a slight increase of the residual lithium on the surface, although it also meets the definition herein, it is not the most preferred solution. In Example 8 without doping, both the capacity and the initial efficiency are relatively low. Therefore, selecting suitable elements for doping in the preparation process of the cathode material is beneficial to improving the electrochemical performance of the cathode material.

From the test data of Examples 2 and 5, it can be seen that both of them were prepared based on the ternary cathode material with high nickel content of Ni:Co:Mn=90:5:5, with the difference of different doped W contents. As increasing the W content, the $R_2$-$R_1$ value of the obtained cathode material precursor is significantly increased. By comparing the electrochemical performances of the cathode materials prepared by the cathode material precursors, it can be seen that the $R_2$-$R_1$ value of the cathode material precursor of Example 5 is higher, resulting in poor structural stability of the cathode material, so that the discharge capacity and cycle stability of Example 5 are lower than those of Example 2.

From the test data of Examples 3 and 6, it can be seen that both of them were prepared based on the ternary cathode material with an element ratio of Ni:Co:Mn=62:5:28. The $R_2$-$R_1$ value of Example 3 with Nb doped is lower than that of Example 6 with Mg doped. By comparing the electrochemical performances of Examples 6 and 3, it can be seen that an increase in the $R_2$-$R_1$ value within a certain range is beneficial for improving the structural stability of the cathode material, resulting in better discharge specific capacity and high-temperature cycle performance of Example 6. However, by comprehensive analysis on Examples 2 and 5, it can be seen that if the $R_2$-$R_1$ value is too high, the metal element distribution in the cathode material is unbalanced, which may also degrade the structural stability of the cathode material.

From the test data of Examples 1 and 11, it can be seen that due to the reduction of the temperature for the sintering, insufficient energy was available for crystal grain growth in Example 11, leading to the failure to form a single-crystal morphology with a single grain size of 1 $\mu$m to 5 $\mu$m, but a polycrystalline morphology with a single grain size of only 0.88 $\mu$m. In this morphology, there are a large number of grain boundaries among the materials. During charging and discharging, frequent lithium ion deintercalation exacerbates grain boundary dislocations, resulting in poor crystal structural stability and low cycle stability.

From the test data of Examples 1 and 12, it can be seen that the content of free $SO_4^{2-}$ in the cathode material is high, which adversely affects the capacity and rate of the material. In addition, excessive free $SO_4^{2-}$ on the surface also affect the stability of the SEI film, thereby reducing the cycle performance.

From the test data of Examples 13 to 16, it can be seen that when the ternary material cathode materials based on different Ni/Co/Mn contents meet the particle size and the distribution of Ni element and Mn element defined herein, good material structural stability and high cycle performance and capacity retention are obtained.

The above description is only preferred embodiments of the present disclosure and is not intended to limit the present disclosure. For those skilled in the art, the present disclosure can be subject to various modifications and changes. Any modification, equivalent replacement, improvement, and the like made within the spirit and principles of the present disclosure shall fall within the protection scope of the present disclosure.

## Claims

1. A cathode material, **characterized in that** the cathode material has a chemical formula of $Li_nNi_{1-x-y}M_xMn_yO_2$, wherein $0.9{\leq}n{\leq}1.2$, $0<x<1$, $0<y<1$, and M is selected from Co and/or Al,

    the cathode material comprises first particles with the maximum diameter of ${\leq}1.5$ $\mu$m and second particles with the maximum diameter of ${\geq}2.5$ $\mu$m,
    by characterizing the first particles through energy dispersive spectroscopy (EDS), an average value of molar ratios of Ni element and Mn element is denoted as $R_1$, and by characterizing the second particles through energy dispersive spectroscopy (EDS), an average value of molar ratios of Ni element and Mn element is denoted as $R_2$, wherein $0<R_2$-$R_1$.

2. The cathode material according to claim 1, **characterized in that** the cathode material satisfies at least one of the following features:

    (1) in the cathode material, $R_1>0.5$;
    (2) in the cathode material, $R_2>0.6$; and
    (3) in the cathode material, $0<R_2$-$R_1<0.5$.

3. The cathode material according to claim 1, **characterized in that** the cathode material satisfies at least one of the following features:

    (1) the first particles has a mean particle size of 0.5 $\mu$m to 1.5 $\mu$m; and
    (2) the second particles has a mean particle size of 2.5 $\mu$m to 3.5 $\mu$m.

4. The cathode material according to claim 1, **characterized in that** the cathode material satisfies at least one of the following features:

(1) the cathode material has a chemical formula of $Li_nNi_{1-x-y}M_xMn_yM2_zO_2$, wherein $0 \leq z < 1$, and the M2 metal comprises at least one of Zr, Mg, Ti, Ba, Sr, Cr, Zn, V, Cu, Nb, Mo, Sb, Ta, Ca, B, Y and W; and
(2) the cathode material has a chemical formula of $Li_nNi_{1-x-y}M_xMn_yM2_zM3_uO_2$, wherein $0 \leq z < 1$, the M2 metal comprises at least one of Zr, Mg, Ti, Ba, Sr, Cr, Zn, V, Cu, Nb, Mo, Sb, Ta, Ca, B, Y and W, and the M3 metal comprises at least one of Zr, Mg, Ti, Ba, Sr, Cr, Zn, V, Cu, Nb, Mo, Y, B and W.

5. The cathode material according to claim 1, **characterized in that** the cathode material satisfies at least one of the following features:

(1) the cathode material is a single-crystal material, the single-crystal material comprises a plurality of crystal grains, the crystal grain comprises a plurality of primary particles, the plurality of primary particles comprise first particles and/or second particles, and all the primary particles in at least one of the crystal grains exhibit identical orientation; and
(2) the cathode material is a single-crystal material, the single-crystal material comprises a plurality of crystal grains, the crystal grain comprises a plurality of primary particles, the plurality of primary particles comprise first particles and/or second particles, and all the primary particles in at least one of the crystal grains exhibit identical orientation, wherein the primary particles have a mean particle size of 1 μm to 5 μm.

6. The cathode material according to claim 1, **characterized in that** the cathode material has a median particle size of satisfying 2.5 μm ≤ the median particle size ≤ 5 μm.

7. The cathode material according to claim 1, **characterized in that** the cathode material has a sulfate content of ≤ 800 ppm.

8. The cathode material according to claim 1, **characterized in that** the cathode material satisfies at least one of the following features:

(1) the cathode material exhibits a pH satisfying $11.0 \leq pH \leq 12.5$;
(2) the cathode material has a mass content of LiOH accounting for 100 ppm $< m_{LiOH} \leq 1500$ ppm; and
(3) the cathode material has a mass content of $Li_2CO_3$ accounting for 100 ppm $< m_{Li2CO3} \leq 5000$ ppm.

9. The cathode material according to claim 1, **characterized in that** the cathode material satisfies at least one of the following features:

(1) the cathode material has a mass content of free lithium accounting for 100 ppm $< m_{Li} < 2000$ ppm;
(2) the cathode material has a specific surface area of 0.5 $m^2/g$ to 1.5 $m^2/g$;
(3) the cathode material has a tap density of 1.5 $g/cm^3$ to 3.0 $g/cm^3$; and
(4) the cathode material has a compaction density of 2.5 $g/cm^3$ to 4.0 $g/cm^3$.

10. A preparation method of a cathode material, **characterized in that** the cathode material comprises:
performing primary sintering on a mixture comprising an oxide precursor of the cathode material and a lithium source, and crushing a product of the primary sintering to obtain the cathode material, wherein by testing through XRD ray, the oxide precursor of the cathode material has diffraction peaks both at 34.4° to 36.4° and at 42.3° to 44.3°.

11. The preparation method according to claim 10, **characterized in that** the cathode material further comprises annealing a hydroxide precursor of the cathode material at 500°C to 900°C for 4 h to 12 h to obtain the oxide precursor of the cathode material, wherein the oxide precursor of the cathode material has a chemical formula of $Ni_aM_bMn_cO$, wherein $0 < a < 1$, $0 \leq b < 1$, $0 < c < 1$, $a+b+c=1$, and M is selected from Co and/or Al.

12. The preparation method according to claim 10, **characterized in that** the preparation method satisfies at least one of the following technical features:

(1) the lithium source comprises at least one of lithium hydroxide, lithium carbonate, lithium nitrate, lithium acetate, lithium sulfate and lithium oxalate;
(2) addition amounts of the lithium source and the cathode material precursor satisfy that a ratio of a molar amount of Li and a total molar amount of all metals in the cathode material precursor is (0.87 to 1.25):1;

(3) the mixture further comprises a metal M2-containing dopant, wherein the M2 metal comprises at least one of Zr, Mg, Ti, Ba, Sr, Cr, Zn, V, Cu, Nb, Mo, Sb, Ta, Ca, B, Y, and W; and

(4) the mixture further comprises a metal M2-containing dopant, wherein addition amounts of the dopant and the oxide precursor containing the cathode material satisfy that: a ratio of a molar amount of M2 and a total molar amount of metals in the oxide precursor containing the cathode material is (0.01 to 0.04):1.

13. The preparation method according to claim 10, **characterized in that** the preparation method satisfies at least one of the following technical features:

(1) a mixing requirement for obtaining the mixture is that: solid phase mixing at 10°C to 50°C for 0.3 h to 3 h;

(2) the primary sintering is performed in an oxygen-containing atmosphere, and a content of oxygen in the oxygen-containing atmosphere is ≥95%;

(3) the primary sintering is performed at a temperature of 700°C to 1000°C; and

(4) the primary sintering has a holding time of 6 h to 48 h.

14. The preparation method according to claim 10, **characterized in that** the cathode material further comprises: mixing a matrix material obtained by crushing and a metal M3-containing coating agent, and performing secondary sintering to obtain the cathode material.

15. A battery, **characterized in that** the battery comprises the cathode material according to any one of claims 1 to 9.

performing primary sintering on a mixture including an oxide precursor of the cathode material and a lithium source, and crushing a product of the primary sintering to obtain the cathode material, where by testing through XRD, the cathode material precursor has diffraction peaks both at 35.4°±1° and at 43.3°±1°.

S10

FIG. 1

FIG. 2a

FIG. 2b

FIG. 2c

Electronic image 33

Spectrogram 29

| Element | wt% | atom% |
|---------|-------|--------|
| C | 12.78 | 25.93 |
| O | 33.85 | 51.56 |
| Mn | 15.39 | 6.83 |
| Co | 5.17 | 2.14 |
| Ni | 30.42 | 12.63 |
| Cu | 2.39 | 0.92 |
| Total | 100.00 | 100.00 |

Electronic image 51

Spectrogram 47

| Element | wt% | atom% |
|---------|-------|--------|
| O | 36.22 | 67.14 |
| Mn | 18.88 | 10.19 |
| Co | 6.68 | 3.36 |
| Ni | 38.21 | 19.30 |
| Total | 100.00 | 100.00 |

FIG. 2d

FIG. 3a

S4800 3.0kV 8.0mm x20.0k SE(M) 2.00um

FIG. 3b

S4800 3.0kV 7.9mm x5.00k SE(M) 10.0um

FIG. 3c

Electronic image 55

| Element | wt% | atom% | Spectrogram 51 |
|---------|-------|-------|---|
| C | 13.43 | 26.70 | |
| O | 35.21 | 52.55 | |
| Mn | 2.05 | 0.89 | |
| Co | 2.85 | 1.15 | |
| Ni | 40.31 | 16.39 | |
| Cu | 6.16 | 2.31 | |
| Total | 100.00 | 100.00 | |

Electronic image 67

| Element | wt% | atom% | Spectrogram 63 |
|---------|-------|-------|---|
| C | 16.30 | 30.91 | |
| O | 35.39 | 50.39 | |
| Mn | 1.67 | 0.74 | |
| Co | 3.44 | 1.28 | |
| Ni | 40.35 | 15.65 | |
| Cu | 2.85 | 1.02 | |
| Total | 100.00 | 100.00 | |

FIG. 3d

FIG. 4a

FIG. 4b

FIG. 4c

FIG. 4d

## INTERNATIONAL SEARCH REPORT

| International application No. |
| --- |
| **PCT/CN2024/124255** |

| A. | CLASSIFICATION OF SUBJECT MATTER |
| --- | --- |

H01M 4/505(2010.01)i; H01M 4/525(2010.01)i; H01M 10/0525(2010.01)i; C01G 53/00(2006.01)i

According to International Patent Classification (IPC) or to both national classification and IPC

| B. | FIELDS SEARCHED |
| --- | --- |

Minimum documentation searched (classification system followed by classification symbols)

IPC:H01M4, H01M10, C01G53

Documentation searched other than minimum documentation to the extent that such documents are included in the fields searched

Electronic data base consulted during the international search (name of data base and, where practicable, search terms used)

CNTXT, CNABS, VEN, CNKI: 正极材料, 粒径, 能量散射谱, 第一颗粒, 第二颗粒, 单晶, 烧结, 电池, 掺杂剂, EDS, positive electrode, positive pole, particle diameter, pellet diameter, single crystal, agglomeration, sinter, battery, cell, dopant

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 117476924 A (SHENZHEN BTR NANO TECHNOLOGY CO., LTD.) 30 January 2024 (2024-01-30) <br> description, paragraphs 0006-0048 | 1-4, 6, 8-15 |
| PX | CN 118073560 A (SHENZHEN BTR NANO TECHNOLOGY CO., LTD.) 24 May 2024 (2024-05-24) <br> description, paragraphs 0007-0049 | 1-4, 6, 8-15 |
| X | CN 116454264 A (NINGBO RONBAY NEW ENERGY TECHNOLOGY CO., LTD.) 18 July 2023 (2023-07-18) <br> description, paragraphs 0009, 0019, and 0074-0081, and figure 1 | 1-9, 15 |
| X | BI, Yujing et al. "Simultaneous Single Crystal Growth and Segregation of Ni-Rich Cathode Enabled by Nanoscale Phase Separation for Advanced Lithium-Ion Batteries" <br> *Energy Storage Materials*, Vol. 62, 28 August 2023 (2023-08-28), pages 1-8 <br> abstract, experimental part, and supporting information, figure s2a | 10-14 |
| A | CN 111463411 A (TIANJIN GUOAN MENGGULI NEW MATERIALS SCIENCE & TECHNOLOGY CO., LTD.) 28 July 2020 (2020-07-28) <br> entire document | 1-15 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 December 2024** | **31 December 2024** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/124255**

**C.    DOCUMENTS CONSIDERED TO BE RELEVANT**

| Category* | Citation of document, with indication, where appropriate, of the relevant passages | Relevant to claim No. |
|---|---|---|
| A | CN 114400317 A (SHENZHEN BTR NANO TECHNOLOGY CO., LTD.) 26 April 2022 (2022-04-26)<br>entire document | 1-15 |

Form PCT/ISA/210 (second sheet) (July 2022)

**INTERNATIONAL SEARCH REPORT**
Information on patent family members

International application No.

**PCT/CN2024/124255**

| Patent document cited in search report | | | Publication date (day/month/year) | Patent family member(s) | Publication date (day/month/year) |
|---|---|---|---|---|---|
| CN | 117476924 | A | 30 January 2024 | None | |
| CN | 118073560 | A | 24 May 2024 | None | |
| CN | 116454264 | A | 18 July 2023 | None | |
| CN | 111463411 | A | 28 July 2020 | None | |
| CN | 114400317 | A | 26 April 2022 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311334878